# NEW EUROPEAN PATENT SPECIFICATION

(11) **EP 0 977 301 B2**
(45) Date of publication and mention of the opposition decision: **02.01.2019**
(45) Mention of the grant of the patent: 08.08.2007
(21) Application number: 98114047.8
(22) Date of filing: 28.07.1998
(51) Int. Cl.: H01P 5/18, H03G 3/30

(54) **Mobile phone**
Mobiltelefon
Téléphone mobile

(43) Date of publication of application: 02.02.2000
(73) Proprietor: IPCom GmbH & Co. KG, 82049 Pullach (DE)
(72) Inventor: Jensen, Peter, 9000 Aalborg (DK); Hinrichsen, Carsten, 9000 Aalborg (DK); Norholm, Niels Ole, 9220 Aalborg (DK)
(74) Representative: Vossius & Partner Patentanwälte Rechtsanwälte mbB

(56) References cited:
- EP-A- 0 611 100
- EP-A- 0 790 503
- EP-A- 0 859 464
- EP-A1- 0 611 100
- EP-A2- 0 859 464
- EP-B1- 0 790 503
- DE-A1- 3 343 540
- DE-A1- 3 827 429
- DE-C2- 2 246 487
- DE-C2- 2 607 530
- DE-C2- 3 608 471
- FR-A1- 2 542 930
- FR-A1- 2 685 583
- GB-A- 2 310 342
- JP-A- H08 149 000
- JP-A- H09 186 587
- US-A- 3 927 384
- US-A- 4 078 212
- US-A- 4 259 744
- US-A- 4 426 734
- US-A- 4 629 999
- US-A- 4 809 356
- US-A- 4 855 691
- US-A- 4 887 052
- US-A- 5 059 924
- US-A- 5 363 071
- US-A- 5 363 071
- US-A- 5 680 067
- US-A- 5 686 864
- US-A- 5 774 017
- US-A- 5 774 017
- US-A- 5 923 196

## Description

### Prior Art

The invention proceeds from the mobile phone in accordance with the generic class of the independent patent claims. Such a mobile phone is described in EP-A-0859464.

It is already well known, that power amplifiers, which are used for radio transmitters in mobile phones must allow a precise control of the power level of the output radio frequency signal. Therefore, the output radio frequency signal has to be coupled from the output of the power amplifier into a control loop.

It is also already well known to use mobile phones for two frequency bands. The Motorola "Micro Tac 8900" mobile phone allows automatic shifting between the GSM 900 MHz and the GSM 1800 MHz frequency band. DE 26 07 530 C2 discloses a radio transmitter/receiver operating in two frequency bands. The modulated oscillator signal of the two oscillators are supplied via an inductive coupler to an amplifier.

### Advantages of the invention

The mobile phone having the characterizing features of the independent patent claims, has the advantage, that two or more control loops which are sharing the same loop control can use a common coupler for coupling the output signals of the control loops back into the control loops. Therefore, further couplers can be saved as well as combining filters or switches to connect an input port of the common loop control to different couplers. This saves space and costs.

In multiband mobile phones, common loop controls may be shared by control loops of voltage control oscillators generating signals at frequencies in different frequency bands. Such common loop controls are independent on frequencies.

The features of the dependent patent claim enable further improvements of the invention. A very simple realization of such a coupler consists in utilizing at least three adjacent transmission lines and to profit from the physical effect of coupling of alternating current between them. This also saves costs.

Further space can be saved by realizing the transmission lines as strip lines embedded into a printed circuit board. This configuration allows also the realization of a common coupler for more than two control loops.

A further advantage results by grounding the third one of the at least three transmission lines at a second end via a resistor, whereby the first end of the third one of the at least three transmission lines constitutes a common coupling port. Therefore, disturbing signals at an output port of the common coupler are not coupled to the common coupling port.

### Drawings

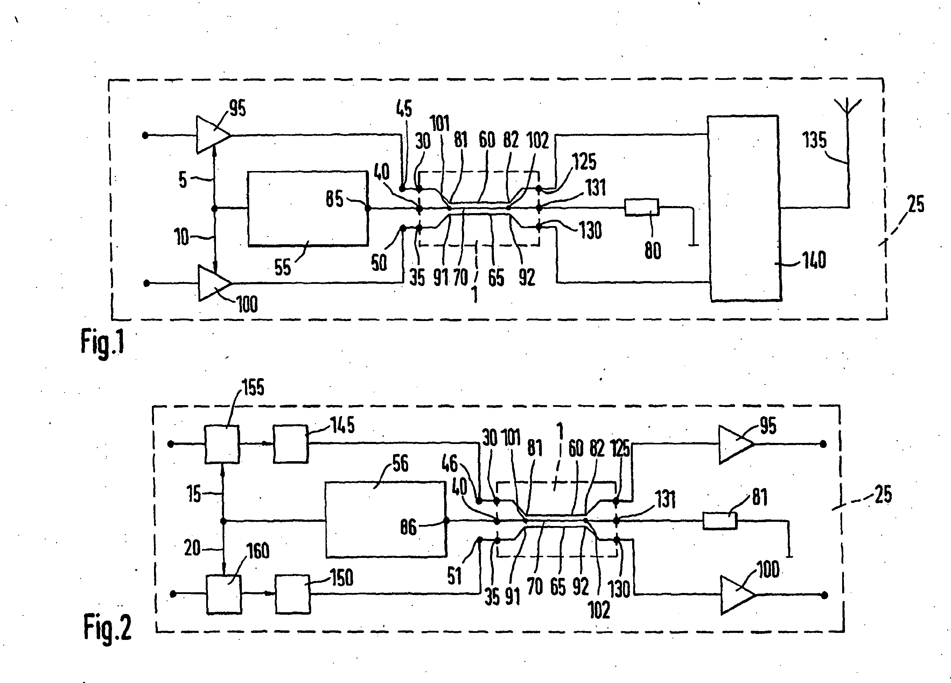

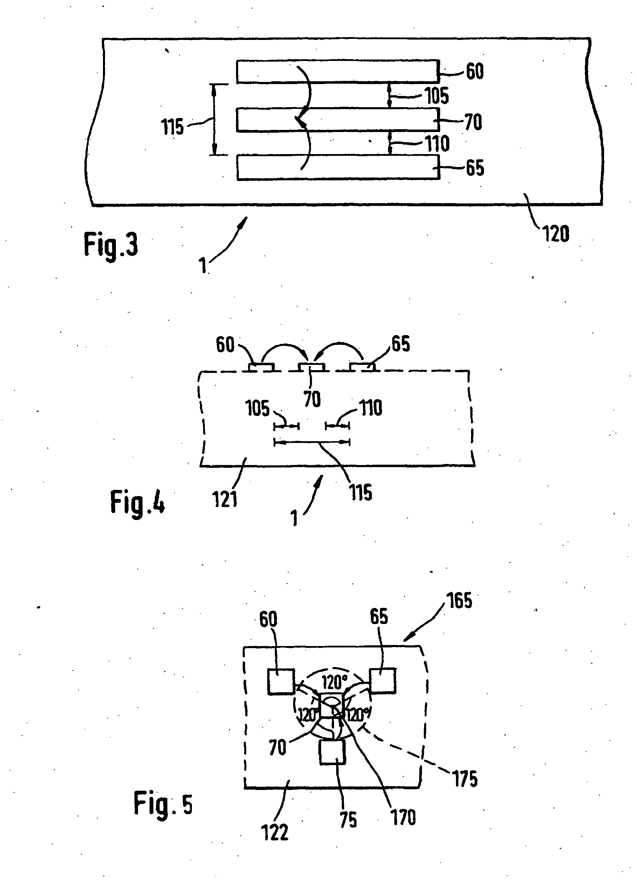

An exemplary embodiment of the invention is shown in figure 2 and explained in greater detail in the description below. Figure 1 shows a block diagram of a mobile phone with a common loop control for the control loops of two power amplifiers for different frequency bands, figure 2 a block diagram of an embodiment of the invention with a common loop control for the control loops of two voltage controlled oscillators for different frequency bands, figure 3 a realization of a common coupler using three transmission lines embedded into a printed circuit board, figure 4 a realization of a common coupler with three transmission lines on a surface of a printed circuit board and figure 5 a realization for a common coupler with four transmission lines embedded into a printed circuit board.

### Description

In figure 1, 25 designates a mobile phone for use in two separate frequency bands. Therefore, in a transmission path of the mobile phone 25 there is provided a first power amplifier 95 for amplifying signals at frequencies in a first frequency band and a second power amplifier 100 for amplifying signals at frequencies in a second frequency band. Preceeding transmission stages of the transmission path and other components of the mobile phone 25 e.g. for reception of signals are not shown in figure 1. The amplification of the first power amplifier 95 is controlled by a first control loop 5 and the amplification of the second power amplifier 100 is controlled by a second control loop 10. Therefore, an output 45 of the first power amplifier 95 is coupled back into the first control loop 5 and therefore represents an output port of the first control and therefore represents an output port of the first control loop 5. An output 50 of the second power amplifier 100 is coupled back into the second control loop 10 and therefore represents an output port of the second control loop 10. For coupling back the output signals of the first power amplifier 95 and the second power amplifier 100 into their corresponding control loop 5, 10, a common coupler 1 is used. A first input port 30 of the common coupler 1 is connected to the output port 45 of the first power amplifier 95 and a second input port 35 of the common coupler 1 is connected to the output port 50 of the second power amplifier 100. The first input port 30 is connected to a first end 81 of a first transmission line 60 and the second input port 35 is connected to a first end 91 of a second transmission line 65. The first transmission line 60, the second transmission line 65, and a third transmission line 70 in the middle between the first transmission line 60 and the second transmission line 65 are arranged parallel to each other. The first transmission line 60 and the second transmission line 65 are therefore arranged adjacent to the third transmission line 70. This arrangement of the three transmission lines 60, 65, 70 provides a coupling of a certain amount of signal power of the signals on the first transmission line 60 and the second transmission line 65 to the third transmission line 70. Supposing, that the first power amplifier 95 amplifies signals at frequencies in the GSM 900 MHz frequency band (GSM = Global System for Mobile Communications) and that the second power amplifier 100 amplifies signals at frequencies in the GSM 1800 MHz frequency band, the signals coupled from the first transmission line 60 and the second transmission line 65 to the third transmission line 70 are high frequency signals. As only one of the two power amplifiers 95, 100 is powered at a time, either signals from the first transmission line 60 or signals from the second transmission line 65 are coupled to the third transmission line 70. At a first end 101 of the third transmission line 70, the third transmission line 70 is connected to a common coupling port 40 of the common coupler 1. The common coupling port 40 is connected to an input 85 of a first common loop control 55 which receives the signals coupled from the first transmission line 60 or the second transmission line 65 to the third transmission line 70. The first common loop control 55 is shared by the first control loop 5 and the second control loop 10 and provides a control signal for the first power amplifier 95 and the second power amplifier 100. Only the power amplifier 95, 100, which is actually powered, may be controlled by the control signal of the first common loop control 55. As the first common loop control 55 controls the first power amplifier 95 and the second power amplifier 100 by use of an amplitude modulation technique, it is not frequency dependent and therefore can be utilized for the different frequency bands of both power amplifiers 95, 100.

A second end 82 of the first transmission line 60 is connected to a first output port 125 of the common coupler 1. A second end 92 of the second transmission line 65 is connected to a second output port 130 of the common coupler 1. A second end 102 of the third transmission line 70 is connected to ground via a first resistor 80. The output ports 125, 130 of the common coupler 1 are connectable to an antenna 135 via an antenna switch circuit 140, respectively.

In the described example, a system impedance of 50 Ω is chosen for the mobile phone 25. Therefore, the common coupler 1 has an input impedance of 50 Ω at its first input port 30, at its second input port 35, at its common coupling port 40, at its first output port 125 and at its second output port 130. The input impedance at the several ports is input impedance at a third output port 131 of the common coupler 1, which is connected to the second end 102 of the third transmission line 70, is also 50 Ω. The impedance of the antenna 135 is also 50 Ω. Therefore, a signal transmitted to the antenna 135 is not reflected from the antenna 135 back into the transmission path. If the antenna 135 changes its impedance e.g. by demolition, there will be a mismatch and a certain amount of the signal power transmitted to the antenna 135 will be reflected into the transmission path. Thereby, the first resistor 80 ensures, that the signal reflection of the antenna 135 is essentially not coupled to the first common coupling port 40 and so into the first common loop control 55, but to the first resistor 80. Therefore, the control of the amplification of the first power amplifier 95 and the second power amplifier 100 is not disturbed by signal reflection of a mismatched antenna 135.

An embodiment of the invention is shown according to figure 2. In figure 2 same numerals designate same components as in figure 1. Figure 2 shows a transmission stage of the mobile phone 25 preceeding the amplification stage shown in figure 1. In figure 2, the common coupler 1 is the same as described according to figure 1. The first output port 125 of the common coupler 1 is connected to the first power amplifier 95, the second output port 130 of the common coupler 1 is connected to the second power amplifier 100 and the third output port 131 of the common coupler 1 is connected to ground via a second resistor 81. The second resistor 81 has also a resistance of 50 Ω. The first input port 30 of the common coupler 1 is connected to an output 46 of a first voltage controlled oscillator 145. The second input port 35 of the common coupler 1 is connected to an output 51 of a second voltage controlled oscillator 150. The output 46 of ' the first voltage controlled oscillator 145 is an output port of the third control loop 15 and the output 51 of the second voltage controlled oscillator is an output output 51 of a second voltage controlled oscillator 150. The output 46 of the first voltage controlled oscillator 145 is an output port of the third control loop 15 and the output 51 of the second voltage controlled oscillator is an output port of the fourth control loop 20. The common coupling port 40 of the common coupler 1 is connected to an input 86 of a second common loop control 56. The second common loop control 56 is shared by a third control loop 15 and a fourth control loop 20. The third control loop 15 controls the oscillation frequency of the first voltage controlled oscillator 145 via a first phase detector 155. The fourth control loop 20 controls the oscillation frequency of the second voltage controlled oscillator 150 via a second phase detector 160. The first voltage controlled oscillator 145 provides frequencies in the first frequency band and the second voltage controlled oscillator provides frequencies in the second frequency band. Either the first or the second voltage controlled oscillator 145, 150 is powered at a time. Therefore, either signals on the first transmission line 60 or signals on the second transmission line 65 are coupled to the third transmission line 70 and therefore back into the corresponding control loop 15, 20. The second common loop control 56 therefore provides either a control signal for the first phase detector 155 or a control signal for the second phase detector 160. As the second common loop control 56 also provides control signals based on amplitude modulation, it is also independent of frequency and therefore can be used in both separated frequency bands and shared by the third and the fourth control loop 15, 20.

The function of the common coupler 1 is the same as described according to figure 1. Also, the common coupler 1 has an input impedance of 50 Ω at its first input port 30, at its second input port 35, at its common coupling port 40, at its first output port 125, at its second output port 130, and, because of the second resistor 81 of 50 Ω also at its third output port 131. Thereby, the system impedance of the embodiment of the invention according to figure 2 is also chosen to 50 Ω and therefore corresponds to the system impedance of the system according to figure 1. As described above, according to the system shown in figure 1, the signal reflected from the amplification stage in figure 2 with the two power amplifiers 95, 100 back to the common coupler 1 will bis essentially coupled to the second resistor 81, but not to the common coupling port 40 of the common coupler 1 and therefore not into the third or fourth control loop 15, 20. Therefore, the control of the first and the second voltage controlled oscillator 145, 150 is not disturbed by signals reflected from the amplification stage.

Figure 3 shows the common coupler 1 in more detail. The three transmission lines 60, 65, 70 are thereby realized as striplines embedded into a first printed circuit board 120. The distance between the first transmission line 60 and the third transmission line 70 is designated by the numeral 105 and will further be called the first distance. The distance between the second transmission line 65 and the third transmission line 70 is designated by the numeral 110 and will further be called the second distance. The distance between the first transmission line 60 and the second transmission line 65 is designated by the numeral 115 and will further be called the third distance. The first distance 105 and the second distance 110 essentially correspond to each other and are small in comparison with the third distance 115. The first and the second distance 105, 110 is chosen such, that an amount of 10-18 dB is coupled out from the first transmission line 60 to the third transmission line 70 or from the second transmission line 65 to the third transmission line 70. The coupling from the first transmission line 60 or the second transmission line 65 to the third transmission line 70 is indicated in figure 3 by arrows. There is also a signal coupling between the first and the second transmission line 60, 65. Because of the third distance 115 of more than the sum of the first and the second distance 105, 110, there will only be neglectable signal coupling between the first and the second transmission line 60, 65. The outcoupling of signals from the first transmission line 60 or from the second transmission line 65 results together with conventional transmission losses at a loss of signal power of about 0,2 - 0,5 dB on the corresponding transmission line 60, 65.

Another realization of the common coupler 1 is shown in figure 4. According to figure 4, the transmission lines 60, 65, 70 are realized as microstrips on a surface of a second printed circuit board 121. As the three transmission lines 60, 65, 70 according to figure 4 are arranged on the surface of the second printed circuit board 121, the dielectric material between them would be air. In the arrangement of figure 3, the three transmission lines 60, 65, 70 are separated by substrate dielectric material, because they are embedded into the first printed circuit board 120. Because of the different dielectric material between the three transmission lines 60, 65, 70 according to the different realizations of the common coupler 1 in figure 3 and figure 4, the first distance 105, the second distance 110 and the third distance 115 may lightly differ for the microstrip arrangement according to figure 4 in comparison with the stripline arrangement of figure 3 to provide the above described amounts of signal coupling from the first transmission line 60 to the third transmission line 70 and from the second transmission line 65 to the third transmission line 70.

The microstrip arrangement according to figure 4 provides also the third distance 115 greater than the sum of the first distance 105 and the second distance 110. The signal coupling from the first transmission line 60 to the third transmission line 70 or from the second transmission line 65 to the third transmission line 70 in figure 4 is also indicated by arrows.

Figure 5 shows a stripline arrangement of a second common coupler 165 with four transmission lines 60, 65, 70, 75. Thereby, the four transmission lines 60, 65, 70, 75 are embedded into a third printed circuit board 122. As described above, the third transmission line 70 provides a common coupling port. In the arrangement of figure 5, not only signals from the first transmission line 60 and the second transmission line 65 are coupled to the third transmission line 70 and its common coupling port but also signals from a fourth transmission line 75. This is indicated in figur5 by arrows. The second common coupler 165 therefore may be shared by three control loops e.g. in a triple band phone utilizing three power amplifiers for three different frequency bands and three voltage controlled oscillators for the three different frequency bands. Thereby, the distance between the first transmission line 60 and the third transmission line 70, the distance between the second transmission line 65 and the third transmission line 70 and the distance between the fourth transmission line 75 and the third transmission line 70 are approximately equal and correspond essentially to the first distance 105 and the second distance 110 which advantageously also are chosen approximately equal according to figure 3 and figure 4. According to figure 5, the third transmission line 70 is placed in the middle between the first transmission line 60, the second transmission line 65, and the fourth transmission line 75. The first transmission line 60, the second transmission line 65 and the fourth transmission line 75 are arranged in such a way, that they have maximum distance between each other to prevent essential coupling of signal power between them. The third transmission line 70 is therefore e.g. placed in the center 170 of a circle 175 and the first transmission line 60, the second transmission line 65 and the fourth transmission line 75 are placed on that circle 175, having an angle distance of 120° between each other, respectively.

It is also possible, to arrange more than three transmission lines on the circle 175 to share the common coupler 1 between more than three control circuits e.g. for mobile phones 25 with more than three frequency bands. The angle distance between adjacent transmission lines on the circle 175 should always be appproximately equal to provide a maximum distance between the transmission lines on the circle 175 and therefore a minimum of signal coupling between the transmission lines on the circle 175. To prevent essential signal coupling between the transmission lines on the circle 175 it could be necessary to enlarge the radius of the circle 175 to provide more distance between adjacent transmission lines on the circle 175. Thereby, the radius of the circle 175 is limited by a predetermined minimum value of e.g. 10 dB for signal coupling from a transmission line on the circle 175 to the third transmission line 70 at the center 170 of the circle 175.

In all figures, same components are designated by the same numerals.

It is also possible, to realize the transmission lines as adjacent discrete cables mounted e.g. on a printed circuit board in an arrangement and with distances between each other according to an arrangement shown in figure 3, figure 4 or figure 5. Thereby, the cables could also be embedded into a common dielectric material.

In figure 1, the amount of signal power which is not coupled from the first transmission line 60 or the second transmission line 65 to the third transmission line 70 is transmitted via the antenna switching circuit 140 to the antenna 135. In figure 2 the amount of signal powerwhich is not coupled from the first transmission line 60 or the second transmission line 65 to the third transmission line 70 is transmitted via the first power amplifier 95 or the second power amplifier 100 to following stages in the transmission path.

## Claims

1. Mobile phone (25) for multiple frequency bands, with a coupler (1) having
two input ports (30, 35) and a common coupling port (40),
a first one of the two input ports (30, 35) being connected to an output port of a first one of at least two control loops (5, 10, 15, 20),
a second one of the two input ports (30, 35) being connected to an output port of a second one of the at least two control loops (5, 10, 15, 20),
the two control loops (5, 10, 15, 20) sharing a common loop control (55),
an input (85) of the common loop control (55) being connected to the common coupling port (40),
the coupler (1) coupling signals received at the first and the second one of the two input ports (30, 35) to the common coupling port (40),
**characterized in that**
the two control loops (15, 20) being realized as control loops (15, 20) of a first and a second one of two voltage controlled oscillators (145, 150), each voltage controlled oscillator (145, 150) generating signals at a frequency in a different frequency band,
wherein the coupler (1) comprises three transmission lines (60, 65, 70),
a first one of the three transmission lines (60, 65, 70) having at a first end (81) the first one of the at least two input ports (30, 35),
a second one of the three transmission lines (60, 65, 70) having at a first end (91) the second one of the two input ports (30, 35),
a third one of the three transmission lines (60, 65, 70) having at a first end (101) the common coupling port (40),
the first transmission line (60), the second transmission line (65) and the third transmission line (70) in the middle between the first and second transmission lines being arranged parallel to each other,
the first and second transmission lines being arranged adjacent to the third transmission line (70) by a first and second distance (105, 110), respectively,
wherein the sum of the first distance (105) and second distance (110) is smaller than a third distance (115) between the first transmission line (60) and the second transmission line (65);
that at least a first predetermined part of the signal power at the first or second one of the at least two input ports (30, 35) is coupled to the common coupling port (40), with a neglectable signal coupling between the first and the second transmission lines (60 and 65, respectively), and
wherein the transmission lines (60, 65, 70) are realized as strip lines embedded into a printed circuit board (120).

2. Mobile phone (25) for multiple frequency bands, with a coupler (1) having t
wo input ports (30, 35) and a common coupling port (40),
a first one of the two input ports (30, 35) being connected to an output port of a first one of at least two control loops (5, 10, 15, 20),
a second one of the two input ports (30, 35) being connected to an output port of a second one of the at least two control loops (5, 10, 15, 20),
the two control loops (5, 10, 15, 20) sharing a common loop control (55), an input (85) of the common loop control (55) being connected to the common coupling port (40), the coupler (1) coupling signals received at the first and the second one of the two input ports (30, 35) to the common coupling port (40),
**characterized in that**
the two control loops (15, 20) being realized as control loops (15, 20) of a first and a second one of two voltage controlled oscillators (145, 150), each voltage controlled oscillator (145, 150) generating signals at a frequency in a different frequency band,
wherein the coupler (1) comprises three transmission lines (60, 65, 70),
a first one of the three transmission lines (60, 65, 70) having at a first end (81) the first one of the at least two input ports (30, 35),
a second one of the three transmission lines (60, 65, 70) having at a first end (91) the second one of the two input ports (30, 35),
a third one of the three transmission lines (60, 65, 70) having at a first end (101) the common coupling port (40),
the first transmission line (60), the second transmission line (65) and the third transmission line (70) in the middle between the first and second transmission lines being arranged parallel to each other,
the first and second transmission lines being arranged adjacent to the third transmission line (70) by a first and second distance (105, 110), respectively,
wherein the sum of the first distance (105) and second distance (110) is smaller than a third distance (115) between the first transmission line (60) and the second transmission line (65);
that at least a first predetermined part of the signal power at the first or second one of the at least two input ports (30, 35) is coupled to the common coupling port (40), with a neglectable signal coupling between the first and the second transmission lines (60 and 65, respectively), and
wherein the transmission lines (60, 65, 70) are realized as microstrips on a surface of a printed circuit board (121).

3. Mobile phone (25) according to claim 1 or 2, **characterized in that** the third one of the three transmission lines (60, 65, 70) at a second end (102) is grounded via a resistor (80).

## Patentansprüche

1. Mobiltelefon (25) für mehrere Frequenzbänder mit einem Koppler (1), der Folgendes aufweist:
zwei Eingangsports (30, 35) und einen gemeinsamen Koppelport (40),
wobei ein erster der zwei Eingangsports (30, 35) mit einem Ausgangsport einer ersten von mindestens zwei Regelschleifen (5, 10, 15, 20) verbunden ist,
wobei ein zweiter der zwei Eingangsports (30, 35) mit einem Ausgangsport einer zweiten von den mindestens zwei Regelschleifen (5, 10, 15, 20) verbunden ist,
wobei sich die zwei Regelschleifen (5, 10, 15, 20) eine gemeinsame Schleifensteuerung (55) teilen, wobei ein Eingang (85) der gemeinsamen Schleifensteuerung (55) mit dem gemeinsamen Koppelport (40) verbunden ist,
wobei der Koppler (1) an dem ersten und dem zweiten der zwei Eingangsports (30, 35) empfangene Signale an den gemeinsamen Koppelport (40) ankoppelt,
**dadurch gekennzeichnet, dass**
die zwei Regelschleifen (15, 20) als Regelschleifen (15, 20) für einen ersten und einen zweiten von zwei spannungsgesteuerten Oszillatoren (145, 150) realisiert sind, wobei jeder spannungsgesteuerte Oszillator (145, 150) Signale mit einer Frequenz in einem verschiedenen Frequenzband erzeugt,
wobei der Koppler (1) drei Übertragungsleitungen (60, 65, 70) aufweist,
wobei eine erste der drei Übertragungsleitungen (60, 65, 70) an einem ersten Ende (81) den ersten der mindestens zwei Eingangsports (30, 35) aufweist,
wobei eine zweite der drei Übertragungsleitungen (60, 65, 70) an einem ersten Ende (91) den zweiten der zwei Eingangsports (30, 35) aufweist,
wobei eine dritte der drei Übertragungsleitungen (60, 65, 70) an einem ersten Ende (101) den gemeinsamen Koppelport (40) aufweist,
wobei die erste Übertragungsleitung (60), die zweite Übertragungsleitung (65) und die dritte Übertragungsleitung (70) in der Mitte zwischen der ersten und zweiten Übertragungsleitung parallel zueinander angeordnet sind,
wobei die erste und die zweite Übertragungsleitung neben der dritten Übertragungsleitung (70) in einem ersten bzw. zweiten Abstand (105, 110) angeordnet sind,
wobei die Summe des ersten Abstands (105) und des zweiten Abstands (110) kleiner als ein dritter Abstand (115) zwischen der ersten Übertragungsleitung (60) und der zweiten Übertragungsleitung (65) ist;
dass mindestens ein erster vorbestimmter Teil der Signalleistung an dem ersten oder zweiten der mindestens zwei Eingangsports (30, 35) an den gemeinsamen Koppelport (40) angekoppelt wird, mit einer vernachlässigbaren Signalkopplung zwischen der ersten und der zweiten Übertragungsleitung (60 bzw. 65), und
wobei die Übertragungsleitungen (60, 65, 70) als in eine Leiterplatte (120) eingebettete Streifenleitungen realisiert sind.

2. Mobiltelefon (25) für mehrere Frequenzbänder mit einem Koppler (1), der Folgendes aufweist:
zwei Eingangsports (30, 35) und einen gemeinsamen Koppelport (40),
wobei ein erster der zwei Eingangsports (30, 35) mit einem Ausgangsport einer ersten von mindestens zwei Regelschleifen (5, 10, 15, 20) verbunden ist,
wobei ein zweiter der zwei Eingangsports (30, 35) mit einem Ausgangsport einer zweiten von den mindestens zwei Regelschleifen (5, 10, 15, 20) verbunden ist,
wobei sich die zwei Regelschleifen (5, 10, 15, 20) eine gemeinsame Schleifensteuerung (55) teilen, wobei ein Eingang (85) der gemeinsamen Schleifensteuerung (55) mit dem gemeinsamen Koppelport (40) verbunden ist, wobei der Koppler (1) an dem ersten und dem zweiten der zwei Eingangsports (30, 35) empfangene Signale an den gemeinsamen Koppelport (40) ankoppelt,
**dadurch gekennzeichnet, dass**
die zwei Regelschleifen (15, 20) als Regelschleifen (15, 20) für einen ersten und einen zweiten von zwei spannungsgesteuerten Oszillatoren (145, 150) realisiert sind, wobei jeder spannungsgesteuerte Oszillator (145, 150) Signale mit einer Frequenz in einem verschiedenen Frequenzband erzeugt,
wobei der Koppler (1) drei Übertragungsleitungen (60, 65, 70) aufweist,
wobei eine erste der drei Übertragungsleitungen (60, 65, 70) an einem ersten Ende (81) den ersten der mindestens zwei Eingangsports (30, 35) aufweist,
wobei eine zweite der drei Übertragungsleitungen (60, 65, 70) an einem ersten Ende (91) den zweiten der zwei Eingangsports (30, 35) aufweist,
wobei eine dritte der drei Übertragungsleitungen (60, 65, 70) an einem ersten Ende (101) den gemeinsamen Koppelport (40) aufweist,
wobei die erste Übertragungsleitung (60), die zweite Übertragungsleitung (65) und die dritte Übertragungsleitung (70) in der Mitte zwischen der ersten und zweiten Übertragungsleitung parallel zueinander angeordnet sind,
wobei die erste und die zweite Übertragungsleitung neben der dritten Übertragungsleitung (70) in einem ersten bzw. zweiten Abstand (105,110) angeordnet sind,
wobei die Summe des ersten Abstands (105) und des zweiten Abstands (110) kleiner als ein dritter Abstand (115) zwischen der ersten Übertragungsleitung (60) und der zweiten Übertragungsleitung (65) ist;
dass mindestens ein erster vorbestimmter Teil der Signalleistung an dem ersten oder zweiten der mindestens zwei Eingangsports (30, 35) an den gemeinsamen Koppelport (40) angekoppelt wird, mit einer vernachlässigbaren Signalkopplung zwischen der ersten und der zweiten Übertragungsleitung (60 bzw. 65), und
wobei die Übertragungsleitungen (60, 65, 70) als Mikrostreifen auf einer Oberfläche einer Leiterplatte (121) realisiert sind.

3. Mobiltelefon (25) nach Anspruch 1 oder 2, **dadurch gekennzeichnet, dass** die dritte der drei Übertragungsleitungen (60, 65, 70) an einem zweiten Ende (102) über einen Widerstand (80) mit Masse verbunden ist.

## Revendications

1. Téléphone mobile (25) pour bandes de fréquences multiples, muni d'un coupleur (1) comportant :
deux prises d'entrée (30, 35) et une prise de couplage commune (40) ;
une première des deux prises d'entrée (30, 35) étant connectée à une prise de sortie d'une première d'au moins deux boucles de commande (5, 10, 15, 20) ;
une seconde des deux prises d'entrée (30, 35) étant connectée à une prise de sortie d'une seconde des au moins deux boucles de commande (5, 10, 15, 20) ;
les deux boucles de commande (5, 10, 15, 20) partageant une commande de boucle commune (55),
une entrée (85) de la commande de boucle commune (55) étant connectée à la prise de couplage commune (40) ;
le coupleur (1) couplant à la prise de couplage commune (40) les signaux reçus à la première et à la seconde des deux prises d'entrée (30, 35),
**caractérisé en ce que**
les deux boucles de commande (15, 20) sont réalisées sous la forme de boucles de commande (15, 20) pour un premier et un second de deux oscillateurs commandés en tension (145, 150), chaque oscillateur commandé en tension (145, 150) générant des signaux à une fréquence située dans une bande de fréquences différente, le coupleur (1) comprenant trois lignes de transmission (60, 65, 70) ; une première des trois lignes de transmission (60, 65, 70) comportant la première des au moins deux prises d'entrée (30, 35) à une première extrémité (81) ; une seconde des trois lignes de transmission (60, 65, 70) comportant la seconde des deux prises d'entrée (30, 35) à une première extrémité (91) ; une troisième des trois lignes de transmission (60, 65, 70) comportant la prise de couplage commune (40) à une première extrémité (101) ; la première ligne de transmission (60), la seconde ligne de transmission (65) et la troisième ligne de transmission (70) en position intermédiaire entre les première et seconde lignes de transmission étant disposées parallèlement les unes aux autres, les première et seconde lignes de transmission étant disposes adjacentes à la troisième ligne de transmission (70) à une première et seconde distance respective (105, 110) la somme de la première distance (105) et la seconde distance (110) étant inférieure à une troisième distance (115) entre la première ligne de transmission (60) et la seconde ligne de transmission (65) ; de sorte qu'au moins une première partie prédéterminée de la puissance du signal à la première ou à la seconde des au moins deux prises d'entrée (30, 35) soit couplée à la prise de couplage commune (40), avec un couplage de signaux négligeable entre les première et seconde lignes de transmission (60 et 65 respectivement), et les lignes de transmission (60, 65, 70) étant réalisées sous la forme de bandes noyées dans une carte de circuit imprimé (120).

2. Téléphone mobile (25) pour bandes de fréquences multiples, muni d'un coupleur (1) comportant :
deux prises d'entrée (30, 35) et une prise de couplage commune (40) ;
une première des deux prises d'entrée (30, 35) étant connectée à une prise de sortie d'une première d'au moins deux boucles de commande (5, 10, 15, 20) ;
une seconde des deux prises d'entrée (30, 35) étant connectée à une prise de sortie d'une seconde des au moins deux boucles de commande (5, 10, 15, 20) ;
les deux boucles de commande (5, 10, 15, 20) partageant une commande de boucle commune (55), une entrée (85) de la commande de boucle commune (55) étant connectée à la prise de couplage commune (40), le coupleur (1) couplant à la prise de couplage commune (40) les signaux reçus à la première et à la seconde des deux prises d'entrée (30, 35),
**caractérisé en ce que**
les deux boucles de commande (15, 20) sont réalisées sous la forme de boucles de commande (15, 20) pour un premier et un second de deux oscillateurs commandés en tension (145, 150), chaque oscillateur commandé en tension (145, 150) générant des signaux à une fréquence située dans une bande de fréquences différente,
le coupleur (1) comprenant trois lignes de transmission (60, 65, 70) ;
une première des trois lignes de transmission (60, 65, 70) comportant la première des au moins deux prises d'entrée (30, 35) à une première extrémité (81) ;
une seconde des trois lignes de transmission (60, 65, 70) comportant la seconde des deux prises d'entrée (30, 35) à une première extrémité (91) ;
une troisième des trois lignes de transmission (60, 65, 70) comportant la prise de couplage commune (40) à une première extrémité (101) ;
la première ligne de transmission (60), la seconde ligne de transmission (65) et la troisième ligne de transmission (70) en position intermédiaire entre les première et seconde lignes de transmission étant disposées parallèlement les unes aux autres,
les première et seconde lignes de transmission étant disposées adjacentes à la troisième ligne de transmission (70) à une première et seconde distance respective (105, 110),
la somme de la première distance (105) et la seconde distance (110) étant inférieure à une troisième distance (115) entre la première ligne de transmission (60) et la seconde ligne de transmission (65) ;
telle qu'au moins une première partie prédéterminée de la puissance du signal à la première ou à la seconde des au moins deux prises d'entrée (30, 35) soit couplée à la prise de couplage commune (40) avec un couplage de signaux négligeable entre les première et seconde lignes de transmission (60 et 65 respectivement), et
les lignes de transmission (60, 65, 70) étant réalisées sous la forme de microbandes sur une surface d'une carte de circuit imprimé (121).

3. Téléphone mobile (25) selon la revendication 1 ou 2,
**caractérisé en ce que**
la troisième des trois lignes de transmission (60, 65, 70) est mise à la masse par l'intermédiaire d'une résistance (80) à la seconde extrémité (102).
